# EUROPEAN PATENT APPLICATION

(11) **EP 0 856 855 A2**
(43) Date of publication of application: **05.08.1998**
(21) Application number: 98101482.2
(22) Date of filing: 28.01.1998
(51) Int. Cl.: H01F 17/04

(54) **Printed coil with magnetic layer**

(30) Priority: 04.02.1997 JP 21701/97
(71) Applicant: MITSUBISHI DENKI KABUSHIKI KAISHA, Tokyo 100 (JP)
(72) Inventor: Yamada, Naoshi, Chiyoda-ku, Tokyo 100 (JP); Yokoyama, Yoshinori, Chiyoda-ku, Tokyo 100 (JP); Takeda, Munehisa, Chiyoda-ku, Tokyo 100 (JP); Inubushi, Toshiya, Chiyoda-ku, Tokyo 100 (JP); Kitazaki, Kuraki, Chiyoda-ku, Tokyo 100 (JP); Nukui, Kozo, Chiyoda-ku, Tokyo 100 (JP)
(74) Representative: Popp, Eugen, Dr.

(57) **Abstract**

A core-sheet assembly (30) includes a first sheet portion (1) having non-magnetic and insulating properties, and having a hole (2) of predetermined shape formed therein, a high permeability member (3) arranged in the hole (2), and a second sheet portion (4, 5) having non-magnetic and insulating properties, and bonded to the first sheet portion (1) by an adhesive agent (6). The high permeability member (3) forms a magnetic core. A plurality of conductive paths (20) are passed through the core-sheet assembly (30), and a plurality of conductive paths (22, 23) are formed on the assembly (30) to produce a coil-shaped conductive path around the magnetic core (3).

## Description

The present invention relates to a core included sheet, an inductance element, a transformer and an electromagnetic motor and a functional printed board, a thin light emitting/display device and the like using these parts used in a small-sized electrical device such as a portable electronic device.

Figure 19 shows a conventional printed coil which has been disclosed in e.g. JP-B-564844. In this figure, reference numeral 111 designates an insulating sheet, reference numeral 112 designates a core in an island pattern, reference numeral 113 designates a flat coil in a spiral shape, reference numeral 113A designates a starting end of the flat coil, and reference numeral 113B designates a terminal end of the flat coil.

The operation of the conventional printed coil will be explained. The core 112 and the flat coil 113 are formed by bonding ferromagnetic foil such as iron foil to the insulating sheet in a uniform manner to provide a flexible member and etching the flexible member. A part of magnetic flux which is generated by energizing the flat coil 113 concentrates on the core 112.

Since the arrangement of the conventional printed coil is forced to provide the flat coil 113 with a spiral shape and a flat pattern, there has been created a problem in that if the number of turns of the coil increases, the coil is accordingly made larger. Because the core does not provide a closed magnetic path, there is created a problem in that leakage flux is too large to provide sufficient permeance. Under the circumstances, if the flat coil has an inductance of a few µH up to a few H, the coil is made too large to be applied to a portable electronic device.

It is an object of the present invention to solve these problems, and to provide a core included sheet in a thin shape capable of inexpensively providing a small and thin sheet coil having an inductance of a few µH up to a few H, and an electrical device such as a thin transformer, a thin motor, a highly integrated functional printed board and a thin light emitting/display device using the sheet coil.

According to an first aspect of the present invention, there is provided a core included sheet which comprises a first sheet portion having a non-magnetic property and an insulating property, and having a predetermined shape of hole formed therein; a high permeability member arranged in the hole; and a second sheet portion having a non-magnetic property, and having at least one surface provided with an insulating property; wherein the second sheet portion has the insulated surface bonded to the first sheet portion.

The hole may be a through hole, and the second sheet portion may comprises two pieces wherein each of the pieces has at least one surface provided with an insulating property, and each of the pieces has the insulated surface bonded to the first sheet portion.

According to a second aspect of the present invention, the hole is a blind hole, and the second sheet portion has the insulated surface bonded to a surface of the first sheet portion with the blind hole formed therein.

According to a third aspect of the present invention, the second sheet portion has the other surface formed with a conductive member.

According to a fourth aspect of the present invention, the first sheet portion is made of thermoplastic polyimide.

According to a fifth aspect of the present invention, the second sheet portion is made of thermoplastic polyimide.

According to a sixth aspect of the present invention, there is provided a sheet coil which comprises (1) a core included sheet comprising a first sheet portion having a non-magnetic property and an insulating property, and having a predetermined shape of hole formed therein; a high permeability member arranged in the hole; and a second sheet portion having a non-magnetic property, and having at least one surface provided with an insulating property; wherein the second sheet portion comprises two pieces, each of the pieces has at least one surface provided with an insulating property, and each of the pieces has the insulated surface bonded to the first sheet portion; (2) a magnetic core constituted by the high permeability member; (3) a plurality of conductive paths passing through the core included sheet; and (4) a plurality of conductive paths formed on both surfaces of the core included sheet; wherein the conductive paths passing through and formed on the core included sheet form a coil-shaped conductive path around the magnetic core.

According to a seventh aspect of the present invention, the sheet coil further comprises at least one pair of conductive sheets having a non-magnetic property and an insulating property; the conductive sheets having one surface provided with a first set of conductive paths and having a second set of conductive paths passing therethrough; wherein the conductive sheets are layered on both surfaces of the core including sheet so that the first set of conductive paths of the conductive sheets are located at an outer side and wherein the conductive paths passing through the core included sheet and the first and second sets of conductive paths passing through and on the conductive sheets form coil-shaped conductive paths around the magnetic core.

According to a eighth aspect of the present invention, the conductive sheets are made of thermoplastic polyimide.

According to a ninth aspect of the present invention, the magnetic core is formed in an annular shape to provide a helical shape of a winding structure.

According to a tenth aspect of the present invention, there is provided an electrical device wherein a transformer includes a primary coil or a secondary coil prepared by using sheet coils according to the sixth through ninth aspects.

According to an eleventh aspect of the present invention, there is provided an electrical device wherein an electric motor includes a rotor or a stator prepared by using a sheet coil according to the sixth through ninth aspects.

According to a twelfth aspect of the present invention, there is provided an electric device wherein a functional printed board comprises a core included sheet according to the sixth through ninth aspects with an electronic part mounted thereon.

According to a thirteenth aspect of the present invention, there is provided an electric device wherein a driving circuit is prepared by a functional printed board according to the twelfth aspect, and a thin light emitting/display device is arranged so as to be integrally formed with the functional printed board.

In accordance with the first aspect, when a coil is formed around the insulated sheet portion, a conductor forming the coil can be prevented from short-circuiting. Since the second sheet portion prevents the high permeability member from falling out of the hole, handling during preparation can be facilitated. Use of the sheet-like members can make preparation easy to produce core included sheets in large quantities and at low cost.

In accordance with the second aspect, there are offered advantages similar to those of the first aspect. In addition, the required number of the sheet-like members can be decreased to further make assemblage easy, offering an advantage in that core included sheets can be produced in large quantities and at low cost.

In accordance with the third aspect, when the core included sheet is used to form e.g. a coil, the conductive member can be etched by photolithography to form conductive paths of the coil easily.

In accordance with the fourth aspect, the first sheet portion and the second sheet portion can be bonded together by heating and pressing, dispensing with e.g. an adhesive and improving a heat resistant property and flatness.

In accordance with the fifth aspect, the second sheet portion can be bonded to not only the first sheet portion but also the high permeability member by heating and pressing, dispensing with e.g. an adhesive and providing the sheet coil with a heat resistant property, flatness and a high strength. In addition, the high permeability member can be fixed to restrain vibrations and noise.

In accordance with the sixth aspect, the sheet coil can be easily formed so as to have a three dimensional winding structure, increasing the number of turns without being made larger. Use of the sheet-like members allows the conductive paths to be formed by photolithography, offering an advantage in that coils having a high density of winding can be produced in large quantities and at low cost.

In accordance with the seventh aspect, the sheet coil can be easily formed so as to have a three dimensional and multi layered winding structure, further increasing the number of turns without being made larger.

In accordance with the eighth aspect, the sheet-like members can be bonded together by heating and pressing, dispensing with e.g. an adhesive and offering an advantage in that sheet coils having a heat resistant property and a high flatness can be produced in large quantities and at low cost.

In accordance with the ninth aspect, it is possible to obtain sufficient permeance.

In accordance with the tenth aspect, it is possible to offer an advantage in that the number of turns can increase without making the transformer larger. Use of the sheet-like members allows the conductive path to be formed by photolithography, offering an advantage in that transformers can be produced in large quantities and at low cost.

In accordance with the eleventh aspect, it is possible to offer advantages in that the number of turns can increase to make motor torque greater without making the motor larger. Use of the sheet-like members allows the conductive paths to be formed by photolithography, offering an advantage in that motors can be produced in large quantities and at low cost.

In accordance with the twelfth aspect, it is possible to offer advantages in that the thickness of the functional printed board can be reduced and that functional printed boards with a coil, a transformer or a motor mounted can be produced in large quantities and at low cost.

In accordance with the thirteen aspect, it is possible to offer advantages in that the thickness of the light emitting/display device can be reduced, and that thin light emitting/display devices can be produced in large quantities and at low cost.

In the drawings:
Figure 1 is a longitudinal cross-sectional view of the core included sheet according to a first embodiment of the present invention;
Figure 2 is a transverse cross-sectional view of the core included sheet according to the first embodiment;
Figure 3 is a longitudinal cross-sectional view of the core included sheet according to a second embodiment of the present invention;
Figure 4 is a longitudinal cross-sectional view of the core included sheet according to a third embodiment of the present invention;
Figure 5 is a longitudinal cross-sectional view of the core included sheet according to a fourth embodiment of the present invention;
Figure 6 is a longitudinal cross-sectional view of the core included sheet according to a fifth embodiment of the present invention;
Figure 7 is a longitudinal cross-sectional view of the core included sheet according to a sixth embodiment of the present invention;
Figure 8 is a longitudinal cross-sectional view of the core included sheet according to a seventh embodiment of the present invention;
Figure 9 is a longitudinal cross-sectional view of the core included sheet according to an eighth embodiment of the present invention;
Figure 10 is a plan view of the sheet coil according to a ninth embodiment of the present invention;
Figure 11 is a longitudinal cross-sectional view of the sheet coil according to the ninth embodiment;
Figure 12 is a plan view of another example of the sheet coil according to the ninth embodiment;
Figure 13 is a longitudinal cross-sectional view of the sheet coil according to a tenth embodiment of the present invention;
Figure 14 is a longitudinal cross-sectional view of the sheet coil according to an eleventh embodiment of the present invention;
Figure 15 is a plan view of the transformer according to a twelfth embodiment of the present invention;
Figure 16 is a schematic view of the electric motor according to a thirteenth embodiment of the present invention;
Figure 17 is a longitudinal cross-sectional view of the functional printed broad according to a fourteenth embodiment of the present invention;
Figure 18 is a longitudinal cross-sectional view of the thin light emitting/display device according to a fifteenth embodiment of the present invention; and
Figure 19 is a plan view of a conventional sheet coil.

Now, preferred embodiment of the present invention will be described in detail, referring to the accompanying drawings.

### EMBODIMENT 1

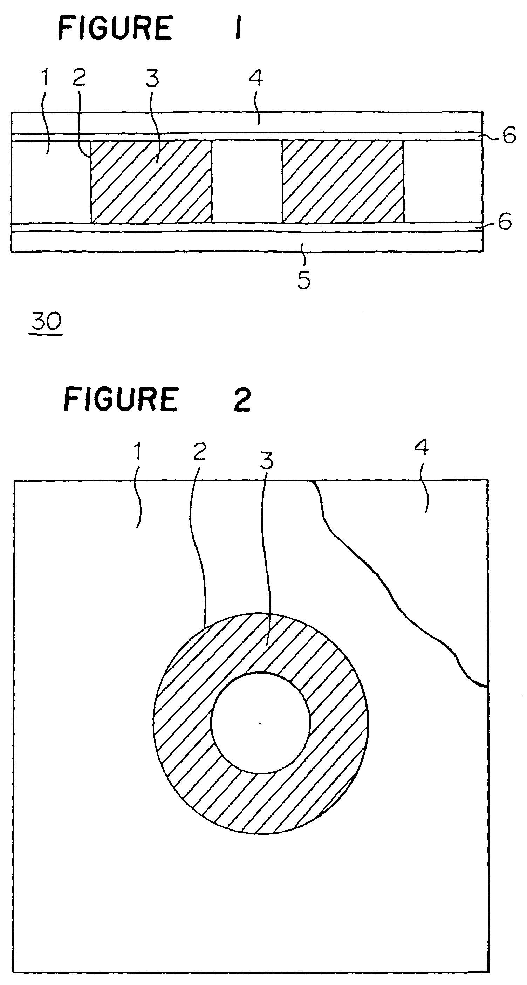

Now, a first embodiment of the present invention will be explained, referring to the accompanying drawings. In Figure 1, there is shown a longitudinal cross-sectional view of the core included sheet according to the first embodiment. In Figure 2, there is shown a transverse cross-sectional view of the core included sheet. In these Figures, reference numeral 1 designates a first sheet portion which has a non-magnetic property and an insulating property and which made of polyimide. Reference numeral 2 designates an annular through hole which is formed in the first sheet portion 1. Reference numeral 3 designates a high permeability member which is made of a high permeability material such as a silicon steel plate, and which has substantially the same thickness as the first sheet portion 1 and substantially the same shape as the through hole 2. Reference numerals 4 and 5 designate second sheet portions which have a non-magnetic property and an insulating property and which are made of polyimide. The second sheet portions are bonded to the first sheet portion 1 and the high permeability member 3 by an adhesive 6 such as an epoxy resin adhesive, providing a core included sheet 30 having a thickness of a several 10 µm up to several mm.

In a core included sheet 30 thus produced, the high permeability member 3 can have the entire surface covered by the first sheet portion 1 and the second sheet portions 4 and 5 having an insulating property to prevent a conductor forming a coil from short-circuiting when the coil is formed around the high permeability member 3. The second sheet portions 4 and 5 can prevent the high permeability member from falling out of the through hole 2, thereby making handling during preparation easy. The high permeability member 3 can be formed in an annular shape as shown in Figure 2 so as to minimize leakage flax, thereby providing sufficient permeance to a sheet coil with core included sheet used therein. The use of the sheet-like members can make preparation easily to establish production in large quantities and at low cost.

The high permeability member 3 may be formed not only in an annular shape but also in a track-like shape, a bar-like shape, a plate-like shape and a shape with a gap formed therein. If the high permeability member 3 has a layered structure with an insulating layer, eddy-current loss can be reduced to improve the performance of a sheet coil with the core included sheet used therein. The high permeability member 3 may be made of a silicon steel plate but also another high permeability material such as an amorphous material, a ferrite and a permalloy, offering similar advantages. The first sheet portion 1 and the second sheet portions 4 and 5 may be made of not only polyimide but also another insulating material having a non-magnetic property, offering similar advantages. The adhesive 6 may be not only the epoxy resin adhesive but also another adhesive as long as the first sheet portion, the second sheet portion 4 and 5, and the high permeability member 3 can be bonded together.

### EMBODIMENT 2

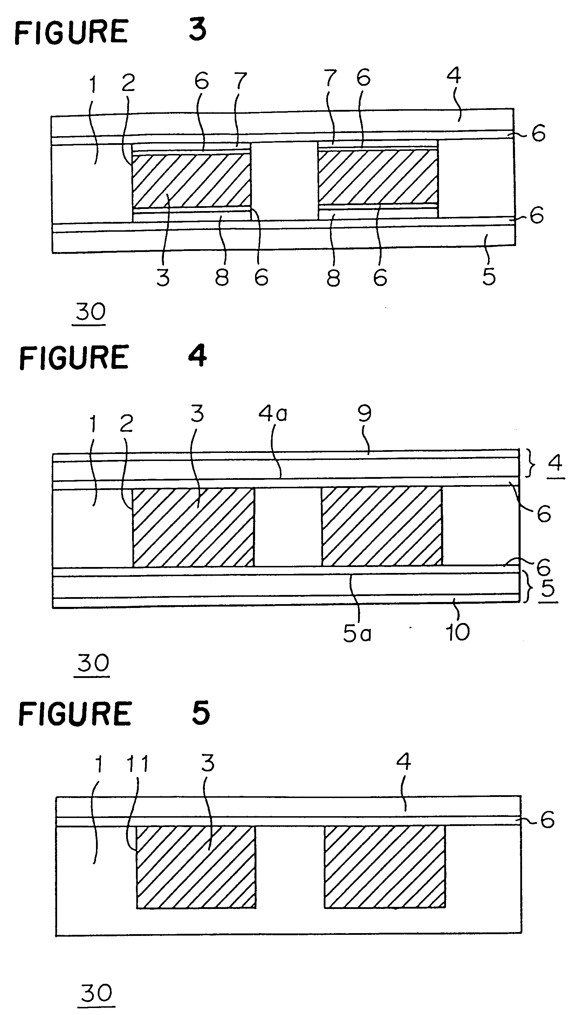

In Figure 3, there is shown a longitudinal cross-sectional view of the core included sheet according to a second embodiment of the present invention. In this Figure, reference numeral 1 designates the first sheet portion which is made of polyimide and which has a non-magnetic property and an insulating property. Reference numeral 2 designates the through hole which is formed in the first sheet portion 1. Reference numeral 3 designates a high permeability member which is made of a high permeability material such as a silicon steel plate, which has a smaller thickness than the first sheet portion 1, and which has substantially the same as the through hole 2 in a horizontal direction. Reference numerals 4 and 5 designates the second sheet portions which are made of polyimide, and which have a non-magnetic property and an insulating property. Reference numerals 7 and 8 designates spacers which are made of a material such as polyimide, and which have a non-magnetic property and an insulating property, which have substantially the same shape as the high permeability member 3 in the horizontal direction, and which are bonded to the high permeability member 3 by adhesive 6. The second sheet portions 4 and 5 are bonded to the first sheet portion 1 and the spacers 7 and 8 by the adhesive 6 such as an epoxy resin adhesive.

The core included sheet 30 thus prepared can offer advantages similar to the first embodiment. In addition, the core included sheet can make outer surfaces of the second sheet portions 4 and 5 flat by adjusting the thickness t of the spacers 7 and 8. When the core included sheet is used to produce a sheet coil, forming of conductive paths by photolithography can be carried out to provide a conductive path pattern with high precision. Since the spacers 7 and 8 can fix the high permeability member 3 in the through hole 2 without gaps, the vibration of the high permeability member 3 applied by a magnetic field can be restrained, decreasing the vibration and making the amount of noise reduced.

Although the spacers 7 and 8 are bonded to the high permeability member 3 by the adhesive 6 in the second embodiment, e.g. a measure to bury gaps by sealing a resin material therein may be adopted, offering similar advantages. Although the spacers 7 and 8 are made of polyimide having a non-magnetic property and an insulating property in the second embodiment, spacers may be made of another non-magnetic and insulating material such as an epoxy resin or a high permeability material, offering similar advantages. Even if one of the spacers 7 and 8 is omitted, similar advantages can be offered.

Although the spacers are arranged in the through hole in the second embodiment, the spacers may be arranged outside of the through hole if the high permeability member 3 is thicker than the first sheet portion 1. These measures can make the outer surfaces of the second sheet portions flat.

### EMBODIMENT 3

In Figure 4, there is shown a longitudinal cross-sectional view of the core included sheet according to a third embodiment of the present invention. In this Figure, reference numeral 1 designates the first sheet portion which is made of polyimide and which is a non-magnetic property and an insulating property. Reference numeral 2 designates the through hole which is formed in the first sheet portion 1. Reference numeral 3 designates the high permeability member which is made of a high permeability material such as a silicon steel plate, which has substantially the same thickness as the first sheet portion 1 and which has substantially the same shape as the through hole 2. Reference numerals 4 and 5 designate second sheet portions which are made of polyimide, which have a non-magnetic property and an insulating property, and each of which has a conductive layer 9 or 10 made of copper. Each of the second sheet portions 4 and 5 has a surface 4a or 5a having an insulating property bonded to the first sheet portion 1 and the high permeability member 3 by the adhesive 6 such as an epoxy resin adhesive.

The core included sheet 30 thus produced can offer advantages similar to the first embodiment. In addition, the core included sheet includes the conductive layer 9 and the conductive layer 10. When the core included sheet is used to produce e.g. a coil, the conductive layers can be etched by photolithography to form conductive paths easy, establishing production in large quantities and at low cost.

The conductive layers 9 and 10 may be made of not only copper but also a conductive material having a good conductivity such as aluminum, gold and silver, offering similar advantages.

If the high permeability member 3 is thinner than the through hole 2, the spacers 7 and 8 may be arranged in the through hole as in the second embodiment. If the high permeability member 3 is thicker than the first sheet portion 1, the spacers may be outside of the through hole.

### EMBODIMENT 4

In Figure 5, there is shown longitudinal cross-sectional view of the core included sheet according to a fourth embodiment of the present invention. In this Figure, reference numeral 1 designates the first sheet portion which is made of polyimide and which has a non-magnetic property and an insulating property. Reference numeral 11 designates a blind hole which is formed in the first sheet portion 1 without passing therethrough. Reference numeral 3 designates the high permeability member which is made of a high permeability material such as a silicon steel plate, which has a thickness substantially the same thickness as the blind hole in the first sheet portion 1, and which has substantially the same shape as the blind hole 11. Reference numeral 4 designates a second sheet portion which is made of polyimide, which has a non-magnetic property and an insulating property, and which is bonded to the first sheet portion 1 and the high permeability member 3 by the adhesive 6 such as an epoxy resin adhesive.

The core included sheet 30 thus prepared can offer advantages similar to the first embodiment. The number of the sheet-like members can be reduced to make assembly easier, establishing production in large quantities and at low cost. Since the first sheet portion is made of a sheet-like member wherein the hole does not pass therethrough, the number of portions to be bonded is small, providing easy preparation and establishing production in large quantities and at low cost.

### EMBODIMENT 5

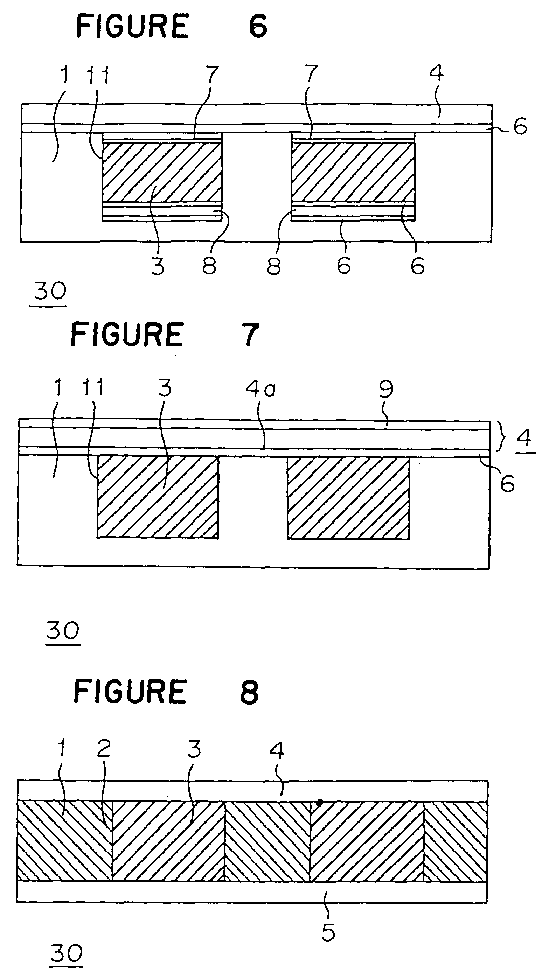

In Figure 6, there is shown a longitudinal cross-sectional view of the core included sheet according to a fifth embodiment of the present invention. In this Figure, reference numeral 1 designates the first sheet portion which is made of polyimide and which has a non-magnetic property and an insulating property. Reference numeral 11 designates the blind hole which is formed in the first sheet portion 1 without passing therethrough. Reference numeral 3 designates the high permeability member which is made of a high permeability material such as a silicon steel plate, which has a smaller thickness than the depth of the blind hole 11 in the first sheet portion 1, and which has substantially the same shape as the blind hole 11 in the horizontal direction. Reference numeral 4 designates the second sheet portion which is made of polyimide and which has a non-magnetic property and an insulating property. Reference numeral 7 and 8 designate the spacers which are made a material such as polyimide having a non-magnetic property and an insulating property, which have substantially the same shape as the high permeability member 3 in a horizontal direction, and which are bonded to the high permeability member 3 by the adhesive 6. The adhesive 6 such as an epoxy resin adhesive is used to bond the second sheet portion 4 to the first sheet portion 1 and the spacer 7, and the spacer 8 to the first sheet portion 1.

The core included sheet 30 thus prepared can offer advantages similar to the fourth embodiment. In addition, the core included sheet can make the outer surface of the second sheet portion 4 flat by adjusting the thickness t of the spacers 7 and 8 as in the second embodiment. When the core included sheet is used to produce a sheet coil, forming of conductive paths by photolithography can be carried out to provide a conductive path pattern with high precision. Since the spacers 7 and 8 can fix the high permeability member 3 into the blind hole 11 without gaps, the vibration of the high permeability member 3 applied by a magnetic field can be restrained, decreasing the vibration and making the amount of noise reduced.

Although the spacers 7 and 8 are bonded to the high permeability member 3 by the adhesive 6 in the fifth embodiment, e.g. a measure to bury gaps by sealing a resin material therein may be adopted, offering similar advantages. Although the spacers 7 and 8 are made of polyimide having a non-magnetic property and an insulating property, the spacers may be made of another non-magnetic and insulating material such as an epoxy resin or a high permeability material, offering similar advantages. Even if one of the spacers 7 and 8 is omitted, similar advantages can be offered. Although the spacers are arranged in the blind hole in the shown embodiment, the spacers may be arranged outside of the blind hole if the high permeability member 3 is thicker than the first sheet portion 1.

### EMBODIMENT 6

In Figure 7, there is shown a longitudinal cross-sectional view of the core included sheet according to a sixth embodiment of the present invention. In this Figure, reference numeral 1 designate the first sheet portion which is made of polyimide and which has a non-magnetic property and an insulating property. Reference numeral 11 designates the blind hole which is formed in the first sheet portion 1 without passing therethrough. Reference numeral 3 designates the high permeability member which is made of a high permeability material such as a silicon steel plate, which has substantially the same thickness as the depth of the blind hole in the first sheet portion 1, and which has substantially the same shape as the blind hole 11. Reference numeral 4 designates a second sheet which is made of polyimide having a non-magnetic property and an insulating property, and which has a conductive layer 9 made of copper. The second sheet portion 4 has a surface 4a having an insulating property bonded to the first sheet portion 1 and the high permeability member 3 by the adhesive 6 such as an epoxy resin adhesive.

The core included sheet 30 thus prepared can offer advantages similar to the fourth embodiment. The use of the sheet-like members can make preparation easy as in the third embodiment. The core included sheet has the conductive layer 9 made of copper. When the core included sheet is used to produce e.g. a coil, the conductive layer can be etched by photolithography to form conductive paths for the coil easily.

The conductive layer 9 may be made of not only copper but also a conductive material having a good conductivity such as aluminum, gold and silver, offering similar advantages.

If the high permeability member 3 is thinner than the depth of the blind hole 11, the spacers 7 and 8 according to the fifth embodiment can be arranged. If the high permeability member 3 is thicker than the first sheet portion 1, the spacer can be arranged outside of the blind hole.

### EMBODIMENT 7

In Figure 8, there is shown a longitudinal cross-sectional view of the core included sheet according to a seventh embodiment of the present invention. In this Figure, reference numeral 1 designates a first sheet portion which is made of thermoplastic polyimide. Reference numeral 2 designates the through hole which is formed in the first sheet portion 1. Reference numeral 3 designates the high permeability member which is made of a high permeability material such as a silicon steel plate, which has substantially the same thickness as the first sheet portion 1, and which has substantially the same shape as the through hole 2. Reference numerals 4 and 5 designate the second sheet portions which are made of polyimide having non-magnetic property and an insulating property, and which are bonded to the first sheet portion 1 by heating and pressing.

The core included sheet 30 thus prepared can offer advantages similar to the first embodiment. Since the first sheet portion 1 can be bonded to the second sheet portions 4 and 5 without use of the adhesive 6, a heat resistant property and flatness can be improved.

Although explanation of the seventh embodiment has been made with respect to application to the first embodiment, the seventh embodiment can be applied to the second through the sixth embodiments, offering similar advantages.

### EMBODIMENT 8

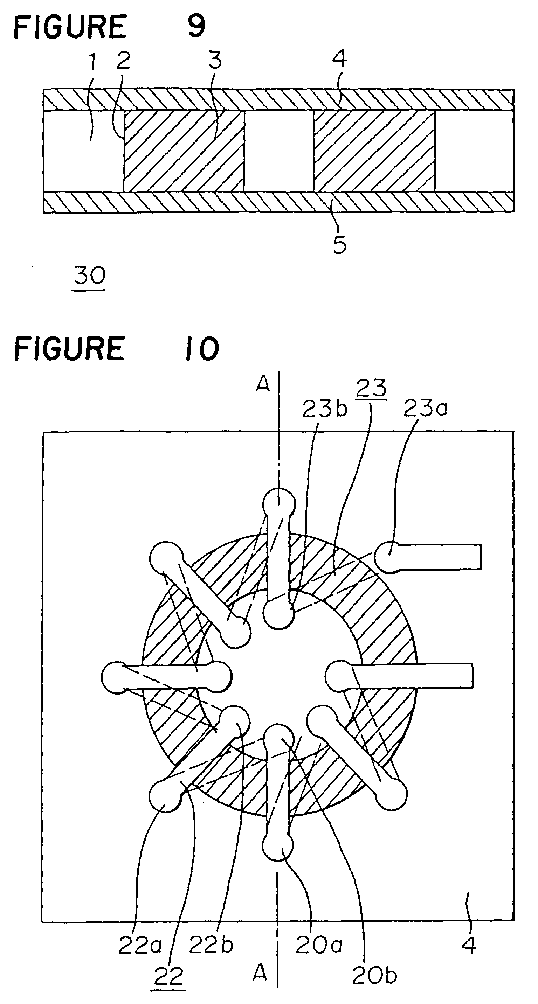

In Figure 9, there is shown a longitudinal cross-sectional view of the core included sheet according to an eighth embodiment of the present invention. In this Figure, reference numeral 1 designates a first sheet portion which is made of polyimide having a non-magnetic property and an insulating property. Reference numeral 2 designates the through hole which is formed in the first sheet portion 1. Reference numeral 3 designates the high permeability member which is made of a high permeability material such as a silicon steel plate, which has substantially the same thickness as the first sheet portion 1, and which has substantially the same shape as the through hole 2. Reference numerals 4 and 5 designate the second sheet portions which are made of thermoplastic polyimide, and which are bonded to the first sheet portion 1 and the high permeability member 3 by heating and pressing.

The core included sheet 30 thus prepared can be offered advantages similar to the first embodiment. Since the use of the thermoplastic polyimide as the material of the second sheet portions 4 and 5 allows the second sheet portions to be bonded to not only the first sheet portion 1 but also the high permeability member 3 without use of an adhesive, a heat resistant property, flatness and strength can be improved. In addition, the high permeability member 3 is fixed, restraining vibration and noise.

Although explanation of the eighth embodiment has been made with respect to application to the first embodiment, the eighth embodiment is applicable to the second through seventh embodiments, offering similar advantages.

### EMBODIMENT 9

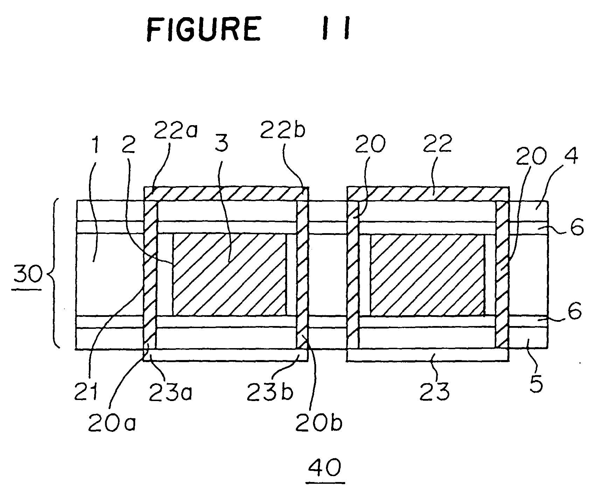

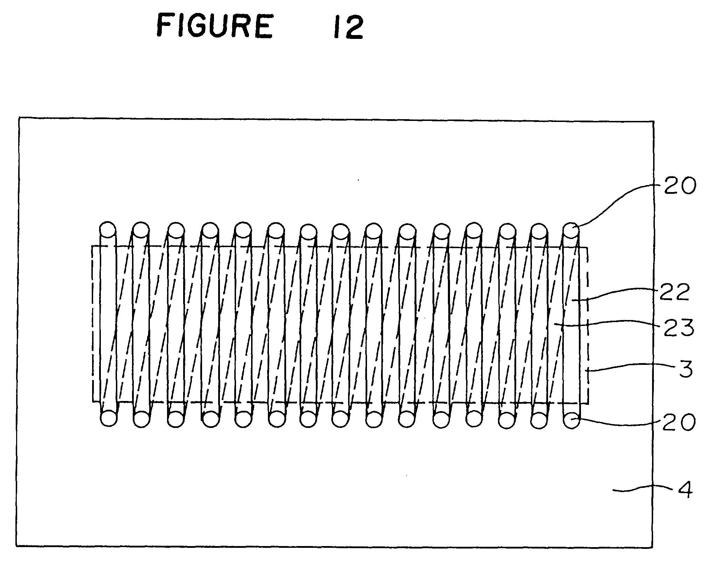

In Figure 10, there is shown a plan view of the sheet coil according to a ninth embodiment of the present invention. In Figure 11, there is shown a longitudinal cross-sectional view of the sheet coil taken along the line A-A of Figure 10. In these Figures, reference numeral 1 designates the first sheet portion which is made of polyimide and which has a non-magnetic property and an insulating property. Reference numeral 2 designates the through hole which is formed in the first sheet portion 1 in an annular shape. Reference numeral 3 designates the high permeability member which is made of a high permeability material such as a silicon steel plate, which has substantially the same thickness as the first sheet portion 1, and which has substantially the same shape as the through hole 2. Reference numeral 4 and 5 designate the second sheet portions which are made of polyimide having a non-magnetic property and an insulating property, and which are bonded to the first sheet portion 1 and the high permeability member 3 by the adhesive 6 such as an epoxy resin adhesive. The first sheet portion 1, the second sheet portions 4 and 5, the high permeability member 3 and the adhesive 6 form the core included sheet 30 with an annular high permeability member according to this embodiment. Reference numeral 20 designates first conductive paths which are prepared by forming through holes 21 in the core included sheet 30 by an excimer laser and depositing copper on the through holes 21 by plating. Reference numeral 22 designates second conductive paths which are made of copper arranged on an outer surface of the second sheet portion 4. Reference numeral 23 designates third conductive paths which are made of copper arranged on an outer surface of the second sheet portion 5. The second conductive paths 22 and the third conductive paths 23 are formed by photolithography and etching after the first conductive paths 20 have been formed. The first conductive paths 20, the second conductive paths 22 and the third conductive paths 23 are arranged in such a three dimensional structure that they encircle the high permeability member 3 so as to provide a helical wiring structure of sheet coil 40 with an annular magnetic core. As shown in Figure 10, a first conductive path 20a connects between an end 22a of each of the second conductive paths 22 and end 23a of each of the third conductive paths 23, and a first conductive path 20b connects between the other end 22b of each of the second conductive paths 22 and the other end 23b of each of the third conductive path 23. Such a structure can provide the sheet coil 40 with a helical wiring structure free from breaking of wiring, can increase the number of turns without making the sheet coil larger, and can include the high permeability member in an annular shape to obtain sufficient permeance. Since the conductive paths can be formed on the sheet-like portions by photolithography, sheet coils 40 can be produced with high precision in large quantities and at low cost.

The high permeability member 30 may be formed not only in an annular shape but also in a track-like shape, a bar-like shape, a plate-like shape or a shape with a gap formed therein. In Figure 12, there is shown a plan view of a sheet coil wherein the high permeability member is formed in a bar-like shape. In this case, the sheet coil is a solenoid coil. Although leakage loss is great as in the conventional sheet coil, the three dimensional arrangement of the sheet coil can extremely reduce the size of the coil in comparison with a conventional sheet coil wherein the coil is arranged in a flat fashion and has the same turns as the coil according to this embodiment. Although it is shown in Figure 12 that the first conductive paths 20 have a diameter set to be equal to the width of the second conductive paths 22 and the third conductive paths 23 and that the first conductive paths 20 are arranged a linear fashion in a horizontal direction, the first conductive paths 20 may be arranged in a zigzag fashion instead of the linear fashion to increase the number of turns if the outer diameter of the first conductive paths 20 is greater than the width of the second and third conductive paths 22 and 23. There is no limitation with respect to the arrangement of the first conductive paths 20 in a horizontal direction.

When the high permeability member has a layered structure with an insulating layer, eddy-current loss can be reduced to improve the performance of the sheet coil. The high permeability member 3 may be made of not only a silicon steel plate but also a high permeability material such as an amorphous material, a ferrite and a permalloy, offering similar advantages. The first sheet portion 1 and the second sheet portions 4 and 5 may be made of polyimide but also another non-magnetic and insulating material such as an epoxy resin, offering similar advantages. The adhesive 6 may be made of not only the epoxy resin adhesive but also another adhesive as long as the first sheet portion, the second sheet portions 4 and 5 and the high permeability member 3 can be bonded together.

The conductive paths 20, 22 and 23 may be made of copper but also another good conductors such as aluminum, gold and copper, offering similar advantages. The formation of the first conductive paths 20 may be made by not only plating but also another measure to ensure conduction of the through hole such as inserting good conductors and sealing paste-like conductors having a low viscosity, offering advantages similar to this embodiment.

Even if the core included sheet according to one of the second through eighth embodiments is used as the core included sheet 30 in this embodiment, similar advantages can be offered.

The through holes 21 are formed by an excimer laser in the ninth embodiment, another measure may be utilized to form the through holes 21, offering similar advantages.

### EMBODIMENT 10

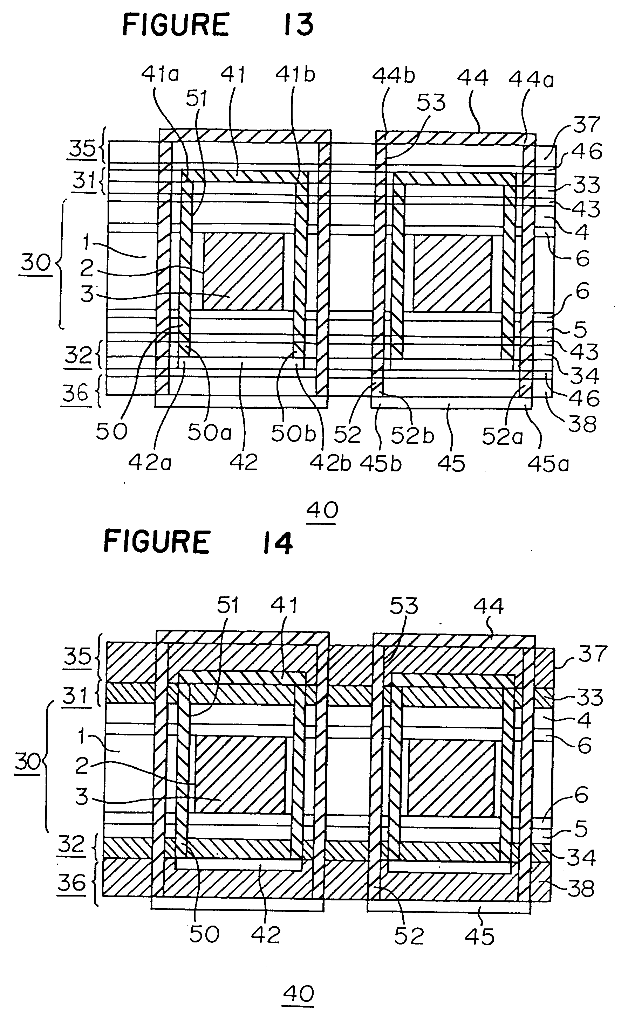

In Figure 13, there is shown a longitudinal cross-sectional view of the sheet coil according to a tenth embodiment of the present invention. In this Figure, reference numeral 1 designates the first sheet portion which is polyimide and which has a non-magnetic property and an insulating property. Reference numeral 2 designates the through hole which is formed in the first sheet portion 1 in an annular shape. Reference numeral 3 designates the high permeability member which is made of a high permeability material such as a silicon steel plate, which has substantially the same thickness as the first sheet portion 1, and which has substantially the same shape as the through hole 2. Reference numerals 4 and 5 designate the second sheet portions which are made of polyimide having a non-magnetic property and an insulating property, and which are bonded to the first sheet portion 1 and the high permeability member 3 by the adhesive 6 such as an epoxy resin adhesive. The first sheet portion 1, the second sheet portions 4 and 5, the high permeability member 3, and the adhesive 6 form the core included sheet 30 according to this embodiment. Reference numerals 31 and 32 designate conductive sheets as a first layer, which are insulating sheets 33 and 34 made of polyimide having a non-magnetic property and an insulating property, and each of which has an outer side formed with a plurality of conductive paths 41 or 42 made of copper. The conductive sheet portions are bonded to the core included sheet 30 by an adhesive 43. Reference numeral 50 designates conductive paths which are prepared by forming through holes 51 in the core included sheet 30 and the first and second conductive sheet 31 and 32 as the first layer by an excimer laser and depositing copper on the through holes by plating. The conductive paths 41 and the conductive paths 42 can be formed by photolithography and etching. The conductive paths 41, 42 and 50 are arranged in such a three dimensional structure that they encircle the high permeability member 3 in an annular shape so as to provide a first arrangement with the high permeability member 3 included as a magnetic core in a helical wiring structure of sheet coil 40. As shown in Figure 13, a conductive paths 50a connect between an end 41a of each of the conductive paths 41 and an end 42a of each of the conductive paths 42, and a conductive paths 50b connect between the other end 41b of each of conductive paths 41 and the other end 42b of each of the conductive paths 42. Reference numerals 35 and 36 indicates first and second conductive sheets as a second layer, which are insulating sheets 37 and 38 made of polyimide having a non-magnetic property and an insulating property, and each of which has an outer side formed with a plurality of conductive paths 44 or 45 made of copper. The first and second conductive sheets as the second layer are bonded to the first and second conductive sheets 31 and 32 as the first layer by an adhesive 46. The conductive paths 44 and the conductive paths 45 are formed by photolithography and etching. Reference numeral 52 designates conductive paths with are prepared by forming through holes 53 in the core included sheet 30, the first conductive sheets 31 and 35 as the first and second layers, and the second conductive sheets 32 and 36 as the first and second layers by an excimer laser and depositing copper on the through holes by plating. The conductive paths 44, 45 and 52 are arranged in such a three dimensional structure that they encircle the high permeability member 3 in the annular shape and the conductive paths 41, 42 and 50 so as to provide a second arrangement with the high permeability member 3 included as a magnetic core in the helical wiring structure of sheet coil 40. As shown in Figure 13, a conductive path 52a connects between an end 44a of each of the conductive paths 44 and an end 45a of each of the conductive paths 45, and a conductive path 52b connects between the other end 44b of each of the conductive paths 44 and the other end 45b of each of the conductive paths 45. Such a structure can provide the helical sheet coil 40 with a two layer of wiring structure free from breaking of wiring can increase the number of turns without making the sheet coil larger, and can include the high permeability member in an annular shape to obtain sufficient permeance. Since the conductive paths can be formed on the sheet-like portions by photolithography, sheet coils can be produced with high precision in large quantities and at low cost.

The high permeability member 3 may be formed not only in an annular shape but also a track-like shape, a bar-like shape, a plate-like shape or a shape with a gap formed therein as in the ninth embodiment. According to this embodiment, the three dimensional arrangement of the sheet coil can extremely reduce the size of coil in comparison with a conventional sheet coil wherein the coil is arranged in a flat fashion and have the same turns as the coil according to this embodiment.

The conductive paths 41, 42, 44, 45, 50 and 52 may be made of not only copper but also a good conductor such as aluminum, gold and silver as in the ninth embodiment, offering similar advantages. The formation of the conductive paths 50 and 52 may be made by not only plating but also another measure to ensure conduction of through holes such as inserting good conductors or sealing paste-like conductors having a low viscosity, offering advantages similar to this embodiment.

Even if the core included sheet according to one of the second through eighth embodiment is used as the core included sheet 30 in this embodiments, similar advantages can be offered. If the second sheet portions 4 and 5 of the core included sheet 30 include the conductive layers 9 and 10 according to the third embodiment, the conductive layers 9 and 10 are utilized to form a part of the first arrangement of the sheet coil.

Although the through holes 51 and 53 are made by an excimer laser in this embodiment, another measure may be utilized to form the through holes 51 and 53, offering similar advantages.

Although explanation of this embodiment has been made of respect to the helical coil having a two layer of wiring structure, the present invention is applicable to coils having a single layered wiring structure or more than two layer of wiring structure.

### EMBODIMENT 11

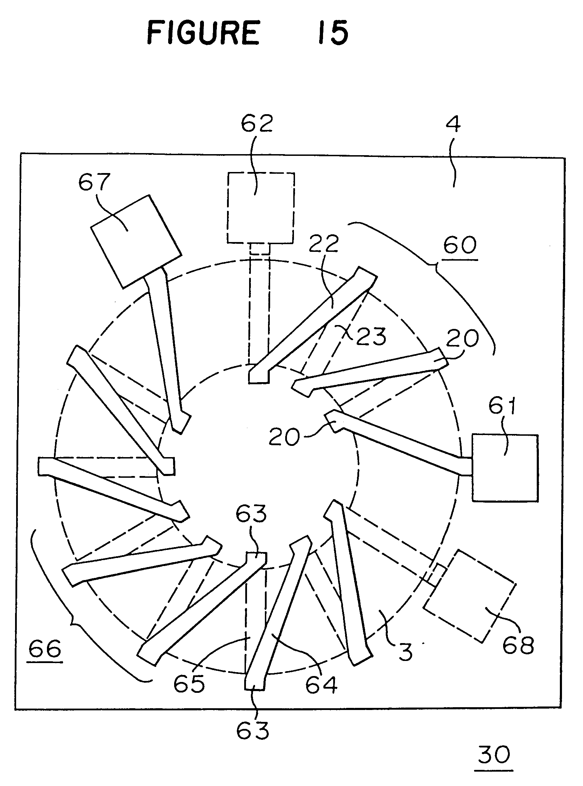

In Figure 14, there is shown a longitudinal cross-sectional view of the sheet coil according to an eleventh embodiment of the present invention. In this Figure, reference numeral 1 designates the first sheet portion which is made of polyimide and which has a non-magnetic property and an insulating property. Reference numeral 2 designates the through hole which is formed in the first sheet portion 1 in an annular shape. Reference numeral 3 designates the high permeability member which is made of a high permeability material such as a silicon steel plate, which has substantially the same thickness as the first sheet portion 1, and which has substantially the same shape as the through hole 2. Reference numerals 4 and 5 designate the second sheet portions which are made polyimide having a non-magnetic property and an insulating property, and which are bonded to the first sheet portion 1 and the high permeability member 3 by the adhesive 6 such as an epoxy resin adhesive. The first sheet portion 1, the second sheet portions 4 and 5, the high permeability member 3, and the adhesive 6 form the core included sheet 30 according to this embodiment. Reference numerals 31 and 32 designate first and second conductive sheets as a first layer, which are insulating sheets 33 and 34 made of thermoplastic polyimide, and each of which has an outer side formed with a plurality of conductive paths 41 or 42 made of copper. The first and second conductive sheets are bonded to the core included sheet 30 by heating and pressing. Reference numeral 50 designates conductive paths which are prepared by forming the through holes 51 in the core included sheet 30 and the first and second conductive sheets 31 and 32 as the first layer by an excimer laser and depositing copper on the through holes by plating. The conductive paths 41 and the conductive paths 42 are formed by photolithography and etching. Reference numeral 35 and 36 designate first and second conductive sheets as a second layer, which are insulating sheets 37 and 38 made of thermoplastic polyimide, and each of which has an outer side formed with a plurality of conductive paths 44 or 45 made of copper. The first and second conductive sheets as the second layer are bonded to the first and second conductive sheets 31 and 32 as the first layer by heating and pressing. The conductive paths 44 and the conductive paths 45 are formed by photolithography and etching. Reference numeral 52 designates conductive paths which are prepared by forming through hole 53 in the core included sheet 30, the first and second conductive sheets 31 and 32 as the first layer, and the first and second conductive sheets 35 and 36 as the second layer by an excimer laser and depositing copper on the through holes by plating. The presence of the conductive paths 41, 42, 44, 45, 50 and 52 can provide a helical sheet coil 40 with a two layer of wiring structure free from breaking of wiring, can increase the number of turns without making the sheet coil larger, and can include the high permeability member in an annular shape to obtain sufficient permeance as in the tenth embodiment. Since the conductive paths can be formed on the sheet-like portions by photolithography, sheet coils can be produced with high precision in large quantities and at low cost. This embodiment has no need for an adhesive, improving a sheet resistant property and flatness.

The high permeability member 3 may be formed not only in an annular shape but also a track-like shape, a bar-like shape, a plate-like shape or a shape with a gap formed therein in this embodiment as in the tenth embodiment. The conductive paths 41, 42, 44, 45, 50 and 52 may be made of not only copper but also a good conductor such as aluminum, gold or silver, offering similar advantages. The formation of the conductive paths 50 and 52 may be made by not only plating but also another measure to ensure conduction of the through holes such as inserting good conductors or sealing paste-like conductors having a low viscosity. Even if the core included sheet 30 is prepared by one of the second through eighth embodiments, similar advantages can be offered. Although the through holes 51 and 53 are made by the excimer laser in this embodiment, another measure may be utilized to form the through holes 51 and 53.

Although explanation of this embodiment has been made with respect to the helical coil having a two layer of wiring structure, the present invention is applicable to coils having a single layered structure or more than two layer of wiring structure.

### EMBODIMENT 12

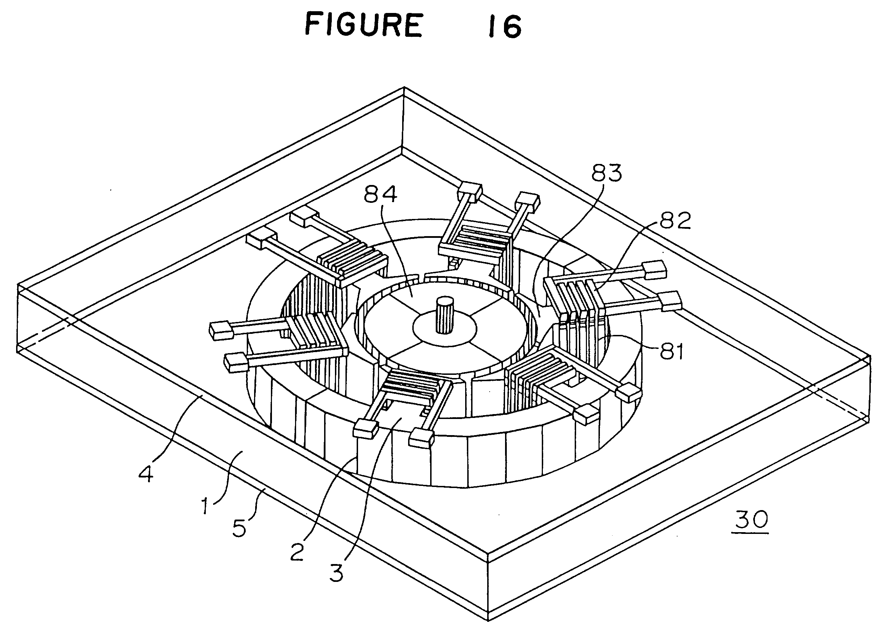

In Figure 15, there is shown a plan view of the transformer according to a twelfth embodiment of the present invention. In this Figure, reference numeral 3 designates the high permeability member which is made of a high permeability material such as a silicon steel plate and is formed in an annular shape. Reference numeral 4 designates a second sheet portion which is polyimide having a non-magnetic property and an insulating property. Reference numeral 22 designates conductive paths which are arranged on an outer surface of the second sheet portion 4. Reference numeral 23 designates conductive paths which are formed on an outer surface of a second sheet portion on the opposite side of the core included sheet 30. The conductive paths 22 and the conductive paths 23 are formed by photolithography and etching after the conductive paths 20 have been formed so as to pass through a core included sheet 30. The conductive paths 20 passing through the core included sheet 30, and the conductive paths 22 and 23 form a helical wiring structure of sheet coil with the high permeability member 3 included as a magnetic core. This portion of the sheet coil works as a primary coil 60 of a transformer. Reference numeral 61 designates an input terminal of the primary coil 60, and reference numeral 62 designates an output terminal of the primary coil 60.

Reference numeral 63 designates conductive paths which are formed in the core included sheet 30 so as to pass therethrough. Reference numeral 64 designates conductive paths which are formed on the outer surface of the second sheet portion 4. Reference numeral 65 designates conductive paths which are formed an outer surface of the second sheet portion on the opposite side of the core included sheet 30. The conductive paths 64 and the conductive paths 65 are formed by photolithography and etching after the conductive paths 63 have been formed so as to pass through the core included sheet 30. The conductive paths 63 passing through the core included sheet 30, and the conductive paths 64 and 65 form a helical wiring structure of sheet coil with the high permeability member 3 included as a magnetic core. This portion of the sheet coil works as a secondary coil 66 of the transformer. Reference numeral 67 designates an input terminal of the secondary coil 66, and reference numeral 68 designates an output terminal of the secondary coil 66. In the transformer thus constructed, both of the primary coil and the secondary coil can be constituted in a sheet-like fashion, increasing the number of turns without making the transformer larger, and allowing the number of turns of the primary and secondary coils of the transformer to be set at an arbitrary value.

The use of the high permeability member 3 in an annular shape can obtain sufficient permeance. Since the conductive paths can be formed on the sheet-like portions by photolithography, transformers can be produced with high precision in larger quantities and at low cost.

The high permeability member 3 may be formed not only in an annular shape but also in a track-like shape, a bar-like shape, a plate-like shape or a shape with a gap formed therein.

Even if the core included sheet 30 is prepared according to one of the second through eighth embodiments, similar advantages can be offered. Although explanation of this embodiment has been made with respect to the helical coil having a single layered wiring structure, the primary and secondary coils may be constituted by coils having not less than two layer of wiring structure.

Although explanation of this embodiment has been made with respect to the transformer, the present invention may be applied to an electrical device with such a structure of transformer, offering advantages similar to this embodiment.

### EMBODIMENT 13

In Figure 16, there is shown a schematic view of the electric motor according to a thirteenth embodiment of the present invention. In this Figure, reference numeral 1 designates the first sheet portion which is made of polyimide and which has non-magnetic property and an insulating property. Reference numeral 2 designates a through hole which is formed in the first sheet portion 1 so as to have a predetermined shape as shown in Figure 16. Reference numeral 3 designates the high permeability member which is made of a high permeability material such as a silicon steel plate, which has substantially the same thickness as the first sheet portion 1, and which has substantially the same shape as the through hole 2. Reference numerals 4 and 5 designate the second sheet portions which are made of polyimide having a non-magnetic property and an insulating property, and which are bonded to the first sheet portion 1 and the high permeability member 3 by an adhesive such an epoxy resin adhesive. Reference numeral 81 designates conductive paths which are prepared by forming through holes in the core included sheet 30 by an excimer laser and depositing copper on the through holes by plating. Reference numeral 82 designates conductive paths which are formed on an outer surface of the second sheet portion 4. The second sheet portion 5 also has an outer surface formed with conductive paths (not shown). The conductive paths which are formed on the second sheet portions 4 and 5 are formed by photolithography and etching after the conductive paths 81 have been formed so as to pass through the core included sheet 30. The conductive paths 81, and the conductive paths on the second sheet portions 4 and 5 form a helical wiring structure of sheet coil with the high permeability member 3 included as a magnetic core, providing respective teeth 83 for a stator. A rotor is constituted by e.g. a magnet 84 which is arranged in the core included sheet 30. The electric motor is constituted by a required number of the stator teeth 83 and the magnet rotor 84.

In accordance with this embodiment, the electric motor can be constituted by a three dimensional structure of sheet coil to increase the number of turns of the teeth 83 without making the electric motor larger, allowing motor torque to be set at an arbitrary value.

Since the conductive paths are formed on the sheet-like portions by photolithography, electric motors can be produced with high precision in large quantities and at low cost.

A similar motor may be constituted by using a sheet coil according to the present invention to form a motor. Such a motor can be produced with high precision in large quantities and at low cost.

Although explanation of this embodiment has been made with respect to such a single layer wiring structure of helical coil, the present invention is also applicable to a case wherein the rotor or the stator is constituted by a more than two layer of wiring structure of coil.

Although explanation of this embodiment has been made with respect to only the motor, the present invention is also applicable to an electrical device having the motor, offering advantages similar to this embodiment.

### EMBODIMENT 14

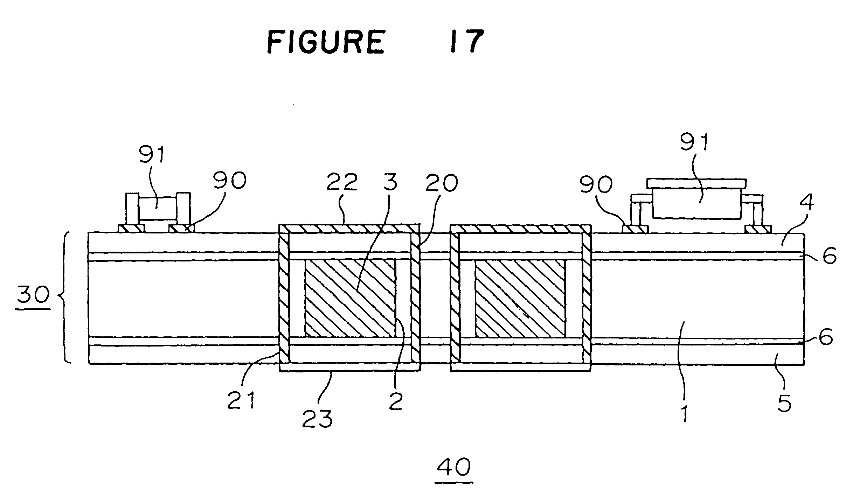

In Figure 17, there is shown a longitudinal cross-sectional view of the functional printed board according to a fourteenth embodiment of the present invention. In this Figure, reference numeral 1 designates the first sheet portion which is made of polyimide and which has a non-magnetic property and an insulating property. Reference numeral 2 designates the through hole which is formed in the first sheet portion 1. Reference numeral 3 designates the high permeability member which is made of a high permeability material such as a silicon steel plate, which has substantially the same thickness as the first sheet portion 1, and which has substantially the same shape as the through hole 1. Reference numeral 4 and 5 designate the second sheet portions which are made of polyimide having a non-magnetic property and an insulating property, and which are bonded to the first sheet portion 1 and the high permeability member 3 by the adhesive 6 such as epoxy resin adhesive. The first sheet portion 1, the second sheet portions 4 and 5, the high permeability member 3, and the adhesive 6 form the core included sheet 30 according to this embodiment. Reference numeral 20 designates conductive paths which are prepared by forming the through holes 21 in the core included sheet 30 by an excimer laser and depositing copper on the through holes by plating. Reference numeral 22 designates conductive paths which are formed on the second sheet portion 4, and reference numeral 23 designates conductive paths which are formed on the second sheet portion 5. The conductive paths 22 and the conductive paths 23 are formed by photolithography and etching after the conductive paths 20 have been formed. The conductive paths 20, 22 and 23 are arranged in such a three dimensional structure that they encircle the annular high permeability member 3 so as to provide a helical wiring structure of sheet coil 40 with an annular magnetic core constituted by the high permeability member 3. Reference numeral 90 designates conductive paths which are formed on the core included sheet 30 of the sheet coil 40 so as to provide a circuit pattern. Reference numeral 91 designates electronic parts such as a chip resistor, a condenser, and an IC, which are mounted on the conductive paths 90.

According to this embodiment, the electric parts 91 can be mounted on the core included sheet 30 as a printed board, reducing the thickness of the printed board with the parts mounted thereon. Especially, an electromagnetic parts such as a coil, which has a large thickness, can be incorporated into the printed broad, extremely reducing the thickness of the entire printed board with parts mounted thereon.

Since the conductive paths 22 forming the sheet coil and the conductive paths 90 forming the circuit pattern can be formed in the same layer, the formation process can be simplified. In addition, the conductive paths can be formed by photolithography, allowing sheet coils and circuit patterns to be produced with high precision in large quantities and at low cost.

Although explanation of the fourteenth embodiment has been made with respect to a case wherein the electronic parts are mounted on the core included sheet in the sheet coil according to the ninth embodiment, the electronic parts may be mounted on the first conductive sheet or the second conductive sheet in the sheet in the sheet coil according to the tenth or eleventh embodiment, offering similar advantages.

Although the electronic parts 91 are mounted on the core included sheet at portions apart from the coil portion in this embodiment, the electronic parts may be mounted above the coil portion.

Electronic parts may be mounted on the core included sheet in the transformer according to the twelfth embodiment or the motor according to the thirteenth embodiment, providing a thin functional sheet member with an electromagnetic part and an electronic part incorporated therein. Since the formation of wiring for an electronic part can be carried out at the same time that the formation of wiring for input and output terminals or control terminals for the transformer or the motor, the assembly process can be eliminated, producing functional sheet members in large quantities and at low cost.

Although explanation of this embodiment has been made with respect to only the functional printed board, the present invention is applicable to an electrical device with a functional printed board in such a structure, offering advantages similar to this embodiment.

### EMBODIMENT 15

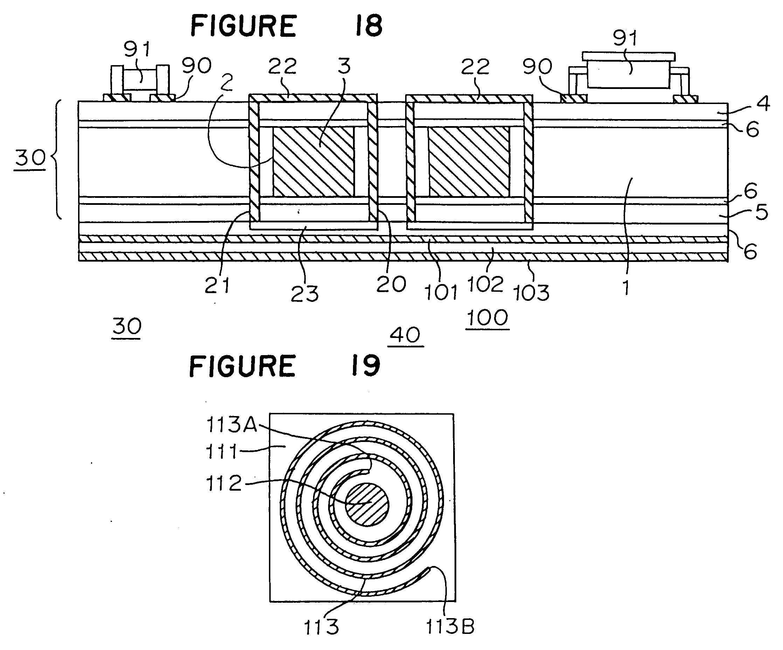

In Figure 18, there is shown a longitudinal cross-sectional view of the thin light emitting/display device according to a fifteenth embodiment of the present invention. In this Figure, reference numeral 1 designates the first sheet portion which is made of polyimide and which has a non-magnetic property and an insulating property. Reference numeral 2 designates the through hole which is formed in the first sheet portion 1. Reference numeral 3 designates the high permeability member which is made of a high permeability material such as a silicon steel plate, which has substantially the same thickness as the first sheet portion 1, and which has substantially the same shape as the through hole 2. Reference numerals 4 and 5 designate the second sheet portions which are made of polyimide having a non-magnetic property and an insulating property, and which are bonded to the first sheet portion 1 and the high permeability member 3 by the adhesive 6 such as an epoxy resin adhesive. The first sheet portion 1, the second sheet portions 4 and 5, the high permeability member 3, and the adhesive 6 form the core included sheet 30 according to this embodiment. Reference numeral 20 designates conductive paths which are prepared by forming the through holes 21 in the core included sheet 30 by an excimer laser and depositing copper on the through holes by plating. Reference numeral 22 designates the conductive paths which are formed on the second sheet portion 4, and reference numeral 23 designates the conductive paths which are formed on the second sheet portion 5. The conductive paths 22 and the conductive paths 23 are formed by photolithography and etching after the conductive paths 20 have been formed. The conductive paths 20, 22 and 23 are arranged in such a three dimensional structure that they encircle the annular high permeability member 3 so as to provide a helical wiring structure of sheet coil 40 with the high permeability member 3 included as a magnetic core. Reference numeral 90 designates conductive paths which are formed on the core included sheet 30 of the sheet coil 40 so as to provide a circuit pattern. Reference numeral 91 designates electronic parts such as a chip resistor, a condenser, and an IC, which are mounted on the conductive paths 90, which work as a driving circuit for a light emitting/display device 100 such as a device employing the principle of electroluminescence (hereinbelow, referred to as the EL device). Reference numeral 100 designates the light emitting/display device which is arranged on a side opposite to the EL driving circuits mounting side of the core included sheet 30, which is constituted by a backside electrode layer 101, a luminescent layer 102 and a transparent electrode layer 103, and which is bonded to the second sheet portion 5 and the sheet coil 40 by e.g. the adhesive 6.

In accordance with this embodiment, the EL driving circuits are constituted by the functional printed board according to the fourteenth embodiment, the EL driving circuits are integrally provided on the backside of the EL device, and wiring of input terminals to the EL electrodes can be simultaneously formed. The EL light emitting/display device can be made thinner, and be produced in large quantities and at low cost.

Although explanation of this embodiment has been made with respect to a case wherein only the EL driving circuits are constituted by the functional printed board according to the fourteenth embodiment, not only EL driving circuits but also another electronic or electromagnetic parts such as the transformer according to the twelfth embodiment and the motor according to the thirteenth embodiment can be mounted on the functional printed board, providing a thin functional sheet member.

Although explanation of this embodiment has been made with respect to a case wherein the EL driving circuits 91 are provided on a side opposite to the mounting side of the EL device 100 of the sheet coil 40, the functional printed board may be make large enough to provide the EL driving circuits on the same side of the EL device 100, or to provide the EL driving circuits and the EL device 100 side by side, offering similar advantages.

Although explanation of this embodiment has been made with respect to an arrangement having only the thin light emitting/display device, the present invention is also applicable to an electrical device having such a thin light emitting/display device, offering advantages similar to this embodiment.

## Claims

1. A core-sheet assembly, comprising:
a first sheet portion (1) having non-magnetic and insulating properties, and having a hole (2) of predetermined shape formed therein;
a high permeability member (3) arranged in the hole (2); and
a second sheet portion (4, 5) having non-magnetic properties, and having at least one surface provided with an insulating property;
wherein the second sheet portion (4, 5) has the insulated surface bonded to the first sheet portion (1).

2. The assembly according to Claim 1, wherein the hole (2) is a through hole, and wherein the second sheet portion comprises two pieces (4, 5), each of the pieces has at least one surface provided with an insulating property, and each of the pieces (4, 5) has the insulated surface bonded to the first sheet portion (1).

3. The assembly according to Claim 1, wherein the hole (2) is a blind hole, and wherein the second sheet portion (4) has the insulated surface bonded to the surface of the first sheet portion (1) with the blind hole formed therein.

4. The assembly according to Claim 1, 2 or 3, wherein the second sheet portion (4) has its opposite surface formed with a conductive member.

5. The assembly according to any one of the Claims 1 to 4, wherein the first sheet portion (1) is made of thermoplastic polyimide.

6. The assembly according to any one of the Claims 1 to 5, wherein the second sheet portion (4, 5) is made of thermoplastic polyimide.

7. A sheet coil comprising:
a core-sheet assembly (30) comprising:
a first sheet portion (1) having non-magnetic and insulating properties, and having a hole (2) of predetermined shape formed therein;
a high permeability member formed as a magnetic core (3) arranged in the hole; and
a second sheet portion (4, 5) having non-magnetic properties, and having at least one surface provided with an insulating property; wherein the second sheet portion (4, 5) comprises two pieces, each of the pieces (4, 5) has at least one surface provided with an insulating property, and each of the pieces (4, 5) has the insulated surface bonded to the first sheet portion (1);
a plurality of conductive paths (20) passing through the core-sheet assembly (30); and
a plurality of conductive paths (22, 23) formed on both surfaces of the core-sheet assembly (30);
wherein the conductive paths passing through and formed on the core-sheet assembly (30) form a coil-shaped conductive path around the magnetic core (3).

8. The sheet coil according to Claim 7, further comprising at least one pair of conductive sheets (33, 34, 37, 38) having non-magnetic and insulating properties; the conductive sheets having one surface provided with a first set of conductive paths (41, 42, 44, 45) and having a second set of conductive paths (50, 52) passing therethrough; wherein the conductive sheets are layered on both surfaces of the core-sheet assembly (30) so that the first set of conductive paths of the conductive sheets are located at an outer side and wherein the conductive paths passing through the core sheet assembly (30) and the first and second sets of conductive paths passing through and formed on the conductive sheets form coil-shaped conductive paths around the magnetic core (3).

9. The sheet coil according to Claim 8, wherein the conductive sheets (33, 34, 37, 38) are made of thermoplastic polyimide.

10. The sheet coil according to Claim 7, 8 or 9, wherein the magnetic core (3) is formed in an annular shape.
